# FASCICULE DE BREVET EUROPEEN

(11) **EP 4 492 469 B1**
(45) Date de publication et mention de la délivrance du brevet: **03.12.2025**
(21) Numéro de dépôt: 24184462.0
(22) Date de dépôt: 25.06.2024
(51) Int. Cl.: H10H 29/01, H10H 29/14, H10H 29/80, H10H 29/854, H10H 20/01, H10H 20/819, H10H 29/85, H10H 29/851, H10H 20/813, H10H 20/818, H10H 20/825

(54) **PROCÉDÉ DE FABRICATION D'UN DISPOSITIF ÉLECTROLUMINESCENT**
VERFAHREN ZUR HERSTELLUNG EINER LICHTEMITTIERENDEN VORRICHTUNG
METHOD FOR MANUFACTURING A LIGHT EMITTING DEVICE

(30) Priorité: 09.07.2023 FR 2307326
(43) Date de publication de la demande: 15.01.2025
(73) Titulaire: Commissariat à l'Energie Atomique et aux Energies Alternatives, 75015 Paris (FR)
(72) Inventeur: SOMMER, Romain, 38054 Grenoble Cedex 09 (FR); MEHREZ, Zouhir, 38054 Grenoble Cedex 09 (FR)
(74) Mandataire: INNOV-GROUP

(56) Documents cités:
- WO-A1-2022/043053
- US-A1- 2019 333 963

## Description

### Domaine technique

L'invention se rapporte au domaine technique de la fabrication de dispositifs électroluminescents.

L'invention trouve notamment son application dans la fabrication de diodes électroluminescentes à base de nanofils, en particulier en nitrure de gallium GaN.

### État de l'art

Un procédé de fabrication d'un dispositif électroluminescent, connu de l'état de la technique, comporte les étapes :
A) utiliser un empilement comprenant successivement :
   - un substrat, possédant une surface ;
   - des matrices de pixels, formées à la surface du substrat, les pixels présentant une forme colonnaire s'étendant suivant la normale à la surface du substrat ;
   - une couche d'encapsulation, agencée pour recouvrir les matrices de pixels ;
   - une couche diélectrique, formée sur la couche d'encapsulation ;
B) effectuer une gravure plasma de la couche diélectrique ;
C) former une résine colorée sur la couche d'encapsulation à l'issue de l'étape B), la résine colorée étant adaptée pour filtrer un spectre d'émission d'un pixel sous-jacent.

La couche d'encapsulation peut être réalisée en nitrure de silicium Si₃N₄. La couche diélectrique est généralement réalisée en dioxyde de silicium SiO₂.

Un tel procédé de l'état de la technique n'est pas entièrement satisfaisant dans la mesure où le fort bombardement de gaz ionisé de l'étape B) est susceptible d'entraîner une dégradation importante des pixels. Cette dégradation est d'autant plus marquée que le facteur de forme (ratio entre la hauteur et la largeur des pixels) des pixels est élevé. Il a été constaté expérimentalement que la partie supérieure des pixels peut devenir biseautée à l'issue de l'étape B).

De plus, lorsque la couche diélectrique est réalisée en dioxyde de silicium SiO₂, l'étape B) est classiquement exécutée avec un plasma fluoré, tel qu'un plasma de tétrafluorure de carbone CF₄. Or, la profondeur de gravure dépend fortement du ratio carbone/fluor du plasma. Une variation de la surface relative du masque carboné peut entraîner un arrêt de gravure (« *etch stop »* en langue anglaise), ce phénomène non désiré étant d'autant plus marqué que l'épaisseur de couche diélectrique à graver est importante.

Des procédés similaires de fabrication de dispositifs électroluminescents sont connus des demandes de brevet US 2019/0333963 A1 et WO 2022/043053 A1 de l'art antérieur.

### Exposé de l'invention

L'invention vise à remédier en tout ou partie aux inconvénients précités. A cet effet, l'invention a pour objet un procédé, selon la revendication 1 en annexe, de fabrication d'un dispositif électroluminescent comportant les étapes :
a) utiliser un empilement comprenant successivement :
   - un substrat, possédant une surface ;
   - des matrices de pixels, formées à la surface du substrat, les pixels présentant une forme colonnaire s'étendant suivant la normale à la surface du substrat ;
   - une couche d'encapsulation, agencée pour recouvrir les matrices de pixels ;
   - une couche diélectrique, formée sur la couche d'encapsulation ;
b) effectuer une gravure directionnelle, suivant la normale à la surface du substrat, d'une partie de la couche diélectrique s'étendant entre les pixels des matrices de pixels ; la couche diélectrique présentant une partie restante à l'issue de l'étape b) ;
c) effectuer une gravure chimique sélective de la partie restante de la couche diélectrique ; l'étape c) étant exécutée avec un agent de gravure chimique autorisant une gravure sélective de la partie restante de la couche diélectrique par rapport à la couche d'encapsulation.

Ainsi, un tel procédé selon l'invention permet de mieux protéger les pixels colonnaires par rapport à l'état de la technique, grâce aux étapes b) et c). En effet, la gravure directionnelle (e.g. plasma) effectuée lors de l'étape b) ne concerne que des zones inter-pixels. La partie supérieure des pixels est préservée d'un éventuel fort bombardement ionisé, car la partie de la couche diélectrique surplombant la partie supérieure des pixels n'est pas gravée lors de l'étape b). La gravure chimique sélective effectuée lors de l'étape c) permet de graver la partie restante de la couche diélectrique sans affecter significativement la partie supérieure des pixels, contrairement à un bombardement de gaz ionisé.

Par ailleurs, la gravure chimique sélective effectuée lors de l'étape c) permet de s'affranchir des problèmes d'arrêt de gravure de l'état de la technique, liés à la gravure plasma, lorsque la couche diélectrique présente une épaisseur élevée (e.g. 8 µm à 10 µm).

Le procédé selon l'invention, en accord avec les revendications dépendantes en annexe, peut comporter une ou plusieurs des caractéristiques suivantes.

Selon une caractéristique de l'invention, le procédé comporte une étape d) de formation d'au moins une résine colorée sur la couche d'encapsulation à l'issue de l'étape c), ladite au moins une résine colorée étant adaptée pour filtrer un spectre d'émission d'un pixel sous-jacent.

Selon une caractéristique de l'invention :
- l'étape b) est exécutée avec un masque de photolithographie possédant des motifs agencés pour faire face aux pixels des matrices de pixels ;
- l'étape c) est précédée d'une étape c₀) de retrait du masque de photolithographie.

Ainsi, un avantage procuré est de protéger la partie supérieure des pixels lors de l'étape b). La partie de la couche diélectrique surplombant la partie supérieure des pixels n'est pas gravée lors de l'étape b), grâce au masque de photolithographie possédant des motifs agencés pour faire face aux pixels des matrices de pixels.

Selon une caractéristique de l'invention, l'étape b) est précédée des étapes :
b₀₁) former une tranchée entre les matrices de pixels adjacentes, possédant une paroi de fond et des parois latérales ;
b₀₂) déposer une couche barrière sur la paroi de fond et sur les parois latérales, la couche barrière étant réalisée dans un matériau choisi en fonction de l'agent de gravure chimique avec lequel est exécutée l'étape c), de manière à obtenir une couche d'arrêt de gravure lors de l'exécution de l'étape c).

Ainsi, un avantage procuré par une tranchée formée entre deux matrices de pixels adjacentes est de limiter les effets de diaphonie (« *crosstalk* » en langue anglaise). De plus, la couche barrière permet de mieux contrôler l'étendue de la gravure chimique sélective (isotrope) effectuée lors de l'étape c).

Selon une caractéristique de l'invention, l'agent de gravure chimique avec lequel est exécutée l'étape c) est l'acide fluorhydrique HF en phase vapeur.

Ainsi, un avantage procuré par l'acide fluorhydrique HF en phase vapeur est d'être compatible, en termes de sélectivité de gravure, avec plusieurs matériaux notamment l'aluminium Al, l'alumine Al₂O₃, le nitrure d'aluminium AlN, ce qui autorise un choix plus important qu'une gravure humide pour les matériaux de la couche barrière et de la couche d'encapsulation.

Selon une caractéristique de l'invention, la couche barrière déposée lors de l'étape b₀₂) est réalisée dans au moins un matériau choisi parmi l'aluminium Al, l'alumine Al₂O₃, le nitrure d'aluminium AlN.

Selon une caractéristique de l'invention, l'étape b) est précédée d'une étape b₀₃) de remplissage de la tranchée de tungstène W à l'issue de l'étape b₀₂).

Ainsi, un avantage procuré est de renforcer la tenue mécanique des tranchées.

Selon une caractéristique de l'invention, l'étape b) est précédée d'une gravure directionnelle initiale, suivant la normale à la surface du substrat, d'une partie superficielle de la couche diélectrique de manière à atteindre une position de l'empilement située au-dessus des pixels des matrices de pixels, à distance de la couche d'encapsulation.

Ainsi, un avantage procuré est de limiter le temps d'opération de la gravure chimique sélective effectuée lors de l'étape c), la partie superficielle de la couche diélectrique étant déjà gravée préalablement. Bien entendu, la position atteinte à la fin de la gravure directionnelle initiale (e.g. une gravure par plasma) doit être suffisamment à distance de la couche d'encapsulation afin de ne pas détériorer la partie supérieure des pixels par le fort bombardement de gaz ionisé.

Selon une caractéristique de l'invention, la couche d'encapsulation de l'empilement utilisé lors de l'étape a) est réalisée dans au moins un matériau choisi parmi l'aluminium Al, l'alumine Al₂O₃, le nitrure d'aluminium AlN.

Selon une caractéristique de l'invention, la couche diélectrique de l'empilement utilisé lors de l'étape a) est réalisée en dioxyde de silicium SiO₂.

### Définitions

- Par « substrat », on entend un support physique autoporté, réalisé dans un matériau de base à partir duquel peut être formé un dispositif électroluminescent. Un substrat peut être une « tranche », également dénommée « plaquette » (« *wafer* » en langue anglaise), qui se présente généralement sous la forme d'un disque issu d'une découpe dans un lingot d'un matériau cristallin.
- Par « pixels », on entend des cellules émettrices de lumière (émissives).
- Par « forme colonnaire », on entend que les pixels présentent chacun un facteur de forme (« *aspect ratio »* en langue anglaise) strictement supérieur à 1, de préférence strictement supérieur à 2, plus préférentiellement strictement supérieur à 3. Le facteur de forme est le ratio entre la hauteur (i.e. épaisseur) du pixel et sa largeur. La hauteur (épaisseur) du pixel est sa dimension suivant la normale à la surface du substrat. Un exemple de structures avec une telle forme colonnaire peut être un nanofil.
- Par « successivement », on entend que les éléments de l'empilement sont disposés les uns sur les autres selon un ordre défini de bas en haut dans des conditions normales d'utilisation, c'est-à-dire suivant la normale à la surface du substrat de manière générale.
- Par « couche », on entend une unique couche ou une pluralité de sous-couches de même nature.
- Par « gravure directionnelle », on entend une gravure anisotrope s'opérant sur une direction privilégiée, en l'espèce suivant la normale à la surface du substrat.
- Par « gravure sélective », on entend que la partie restante de la couche diélectrique peut être gravée sans attaquer la couche d'encapsulation. En pratique, l'agent de gravure est généralement choisi de sorte que la vitesse de gravure de la partie restante de la couche diélectrique est au moins 3 fois supérieure (de préférence au moins 5 fois supérieure, plus préférentiellement au moins 10 fois supérieure) à la vitesse de gravure de la couche d'encapsulation.

### Brève description des dessins

D'autres caractéristiques et avantages apparaîtront dans l'exposé détaillé de différents modes de réalisation de l'invention, l'exposé étant assorti d'exemples et de références aux dessins joints.
Figure 1 est une vue schématique en coupe, illustrant l'étape a) d'un procédé selon l'invention.
Figure 2 est une vue schématique en coupe, illustrant l'étape b₀₁) d'un procédé selon l'invention.
Figure 3 est une vue schématique en coupe, illustrant l'étape b₀₂) d'un procédé selon l'invention.
Figure 4 est une vue schématique en coupe, illustrant l'application d'un masque de photolithographie pour la gravure de la couche barrière.
Figure 5 est une vue schématique en coupe, illustrant la gravure de la couche barrière.
Figure 6 est une vue schématique en coupe, illustrant le retrait du masque de photolithographie illustré à la figure 4.
Figure 7 est une vue schématique en coupe, illustrant l'application d'un masque de photolithographie pour la gravure directionnelle de l'étape b) d'un procédé selon l'invention.
Figure 8 est une vue schématique en coupe, illustrant la gravure directionnelle de l'étape b) d'un procédé selon l'invention.
Figure 9 est une vue schématique en coupe, illustrant l'étape c₀) de retrait du masque de photolithographie illustré à la figure 7.
Figure 10 est une vue schématique en coupe, illustrant la gravure chimique sélective de l'étape c) d'un procédé selon l'invention.
Figure 11 est une vue schématique en coupe, illustrant une gravure directionnelle initiale d'une partie superficielle de la couche diélectrique pouvant être exécutée avant l'étape b).
Figure 12 est une vue schématique en coupe, illustrant l'étape d) d'un procédé selon l'invention.
Figure 13 est une vue schématique en coupe, illustrant l'étape b₀₃) d'un procédé selon l'invention.

Il est à noter que les dessins décrits ci-avant sont schématiques, et ne sont pas nécessairement à l'échelle par souci de lisibilité et pour en simplifier leur compréhension. Les coupes sont effectuées selon la normale à la surface du substrat.

### Exposé détaillé des modes de réalisation

Les éléments identiques ou assurant la même fonction porteront les mêmes références pour les différents modes de réalisation, par souci de simplification.

Un objet de l'invention est un procédé de fabrication d'un dispositif électroluminescent, comportant les étapes :
a) utiliser un empilement comprenant successivement :
   - un substrat 1, possédant une surface 10 ;
   - des matrices de pixels 2, formées à la surface 10 du substrat 1, les pixels 2 présentant une forme colonnaire s'étendant suivant la normale à la surface 10 du substrat 1 ;
   - une couche d'encapsulation 3, agencée pour recouvrir les matrices de pixels 2 ;
   - une couche diélectrique 4, formée sur la couche d'encapsulation 3 ;
b) effectuer une gravure directionnelle, suivant la normale à la surface 10 du substrat 1, d'une partie de la couche diélectrique 4 s'étendant entre les pixels 2 des matrices de pixels 2 ; la couche diélectrique 4 présentant une partie restante 40 à l'issue de l'étape b) ;
c) effectuer une gravure chimique sélective de la partie restante 40 de la couche diélectrique 4 ; l'étape c) étant exécutée avec un agent de gravure chimique autorisant une gravure sélective de la partie restante 40 de la couche diélectrique 4 par rapport à la couche d'encapsulation 3.

### Étape a)

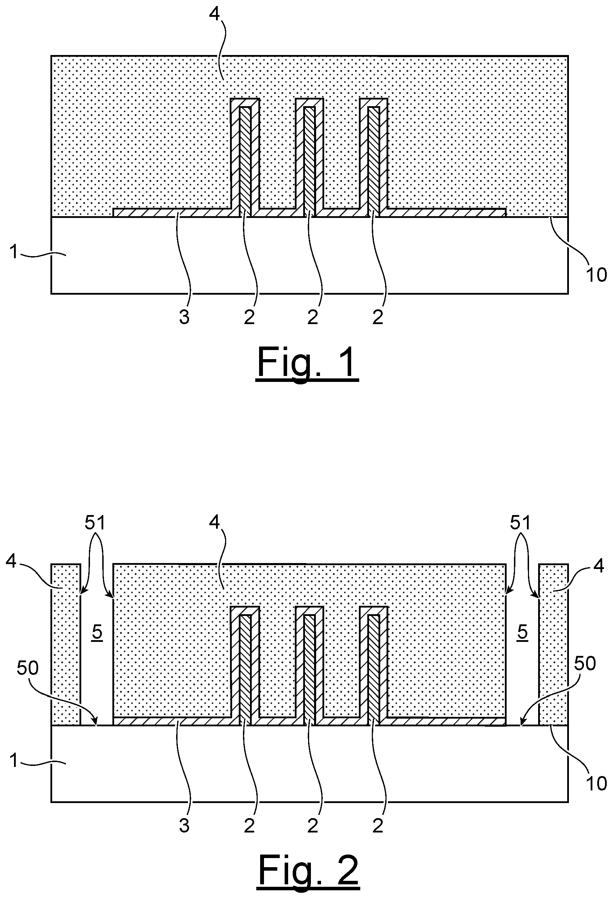

Comme illustré à la figure 1, l'empilement utilisé lors de l'étape a) comprend successivement :
- un substrat 1, possédant une surface 10 ;
- des matrices de pixels 2, formées à la surface 10 du substrat 1, les pixels 2 présentant une forme colonnaire s'étendant suivant la normale à la surface 10 du substrat 1 ;
- une couche d'encapsulation 3, agencée pour recouvrir les matrices de pixels 2 ;
- une couche diélectrique 4, formée sur la couche d'encapsulation 3.

Le substrat 1 est avantageusement réalisé dans un matériau semi-conducteur. A titre d'exemple non limitatif, le substrat 1 peut être réalisé en silicium Si.

A titre d'exemple non limitatif, les pixels 2 peuvent être des nanofils, notamment réalisés en nitrure de gallium GaN. Les pixels 2 forment avantageusement des motifs périodiques.

La couche d'encapsulation 3 de l'empilement utilisé lors de l'étape a) est avantageusement réalisée dans au moins un matériau choisi parmi l'aluminium Al, l'alumine Al₂O₃, le nitrure d'aluminium AlN. Par « au moins un matériau », on entend que la couche d'encapsulation 3 peut être réalisée dans un matériau multicouche comprenant au moins un matériau choisi parmi l'aluminium Al, l'alumine Al₂O₃, le nitrure d'aluminium AlN. La couche d'encapsulation 3 de l'empilement utilisé lors de l'étape a) peut présenter une épaisseur de l'ordre de 1 µm.

La couche diélectrique 4 de l'empilement utilisé lors de l'étape a) est avantageusement réalisée en dioxyde de silicium SiO₂. La couche diélectrique 4 de l'empilement utilisé lors de l'étape a) peut présenter une épaisseur comprise entre 8 µm et 10 µm.

### Étape b)

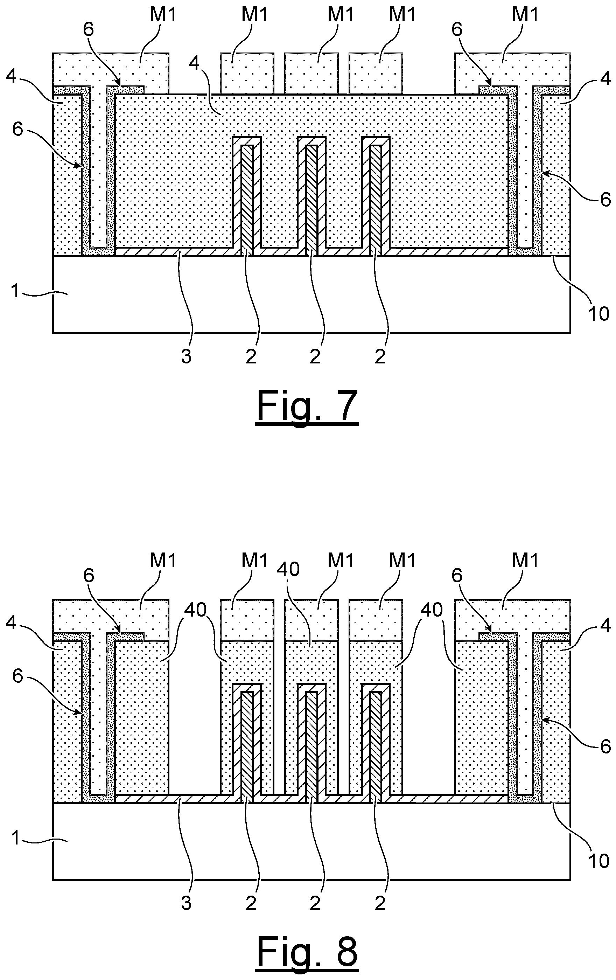

Comme illustré à la figure 8, la gravure directionnelle effectuée lors de l'étape b) est une gravure directionnelle, suivant la normale à la surface 10 du substrat 1, d'une partie de la couche diélectrique 4 s'étendant entre les pixels 2 des matrices de pixels 2.

A titre d'exemple non limitatif, la gravure directionnelle effectuée lors de l'étape b) est une gravure sèche par plasma. Lorsque la couche diélectrique 4 est réalisée en dioxyde de silicium, l'étape b) peut être exécutée avec un plasma fluoré, tel qu'un plasma de tétrafluorure de carbone CF₄.

Comme illustré aux figures 7 et 8, l'étape b) est avantageusement exécutée avec un masque M1 de photolithographie possédant des motifs agencés pour faire face aux pixels 2 des matrices de pixels 2. En d'autres termes, les motifs du masque M1 de photolithographie surplombent les pixels 2 des matrices de pixels 2.

La couche diélectrique 4 présente une partie restante 40 à l'issue de l'étape b). La partie restante 40 de la couche diélectrique 4 s'étend sous les motifs du masque M1 de photolithographie.

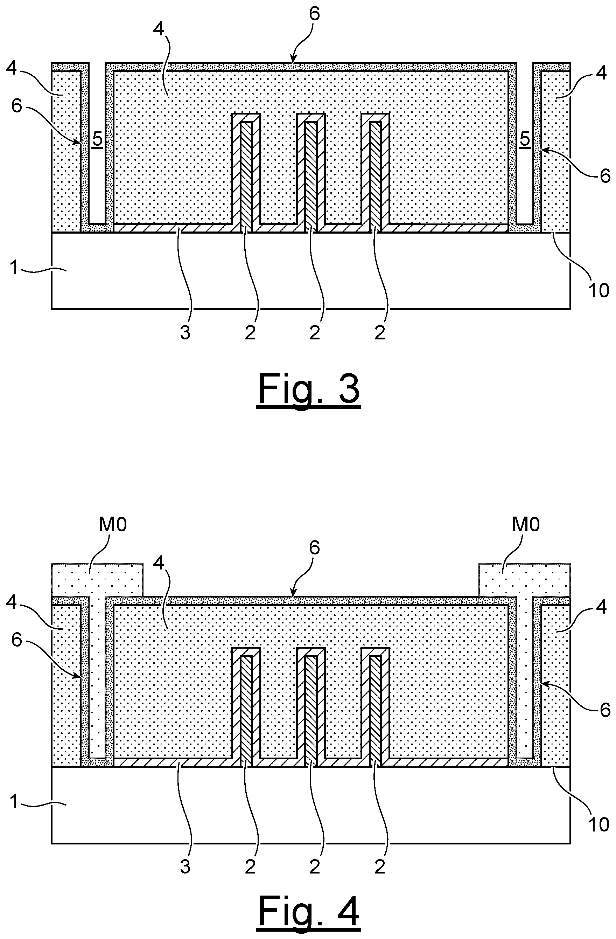

L'étape b) est avantageusement précédée des étapes :
b₀₁) former une tranchée 5 (comme illustré à la figure 2) entre les matrices de pixels 2 adjacentes, possédant une paroi de fond 50 et des parois latérales 51 ;
b₀₂) déposer une couche barrière 6 (comme illustré à la figure 3) sur la paroi de fond 50 et sur les parois latérales 51, la couche barrière 6 étant réalisée dans un matériau choisi en fonction de l'agent de gravure chimique avec lequel est exécutée l'étape c), de manière à obtenir une couche d'arrêt de gravure lors de l'exécution de l'étape c).

Les parois latérales 51 de la tranchée 5 sont formées par la couche diélectrique 4. La paroi de fond 50 de la tranchée 5 est formée par la surface 10 du substrat 1. A titre d'exemple non limitatif, l'étape b₀₁) peut être exécutée par une gravure sèche par plasma. Lorsque la couche diélectrique 4 est réalisée en dioxyde de silicium SiO₂, l'étape b₀₁) peut comporter une gravure par un plasma C₄F₈. L'étape b₀₁) peut comporter une gravure de la couche d'encapsulation 3, par exemple par un plasma chloré (e.g. Cl₂ ou BCl₃) lorsque la couche d'encapsulation 3 est réalisée en aluminium Al ou en alumine Al₂O₃. L'étape b₀₁) est avantageusement exécutée par une gravure directionnelle suivant la normale à la surface 10 du substrat 1.

L'étape b₀₂) est exécutée par une technique de dépôt permettant à la couche barrière 6 de suivre la topologie de surface de l'empilement. Il n'est pas strictement nécessaire que la technique de dépôt produise un dépôt conforme (taux de conformité égal à 100%). En d'autres termes, la technique de dépôt est choisie pour présenter un taux de conformité (ratio entre la largeur des flancs de la couche barrière 6 déposée et l'épaisseur en surface de la couche barrière 6 déposée) permettant de suivre la topologie de surface de l'empilement. A titre d'exemples non limitatifs, la couche barrière 6 peut être formée lors de l'étape b₀₂) par un dépôt chimique en phase vapeur ou par un dépôt de couches atomiques (ALD pour *« Atomic Layer Deposition »* en langue anglaise), ces techniques de dépôt possédant un bon taux de conformité.

La couche barrière 6 déposée lors de l'étape b₀₂) est avantageusement réalisée dans au moins un matériau choisi parmi l'aluminium Al, l'alumine Al₂O₃, le nitrure d'aluminium AlN. Par « au moins un matériau », on entend que la couche barrière 6 peut être réalisée dans un matériau multicouche comprenant au moins un matériau choisi parmi l'aluminium Al, l'alumine Al₂O₃, le nitrure d'aluminium AlN.

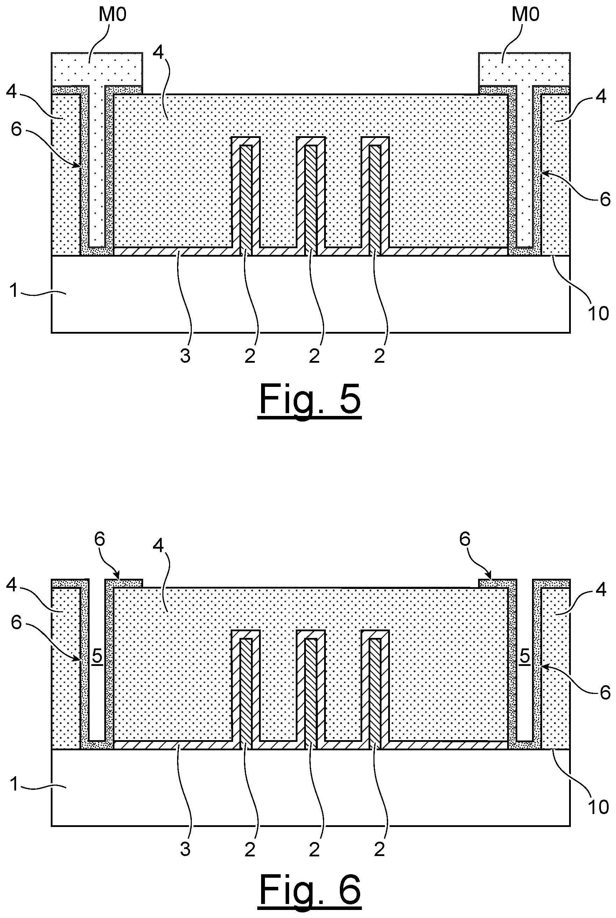

Afin de préparer la gravure directionnelle de l'étape b), une partie de la couche barrière 6 (s'étendant entre les tranchées 5) est gravée à l'aide d'un masque M0 de photolithographie (comme illustré aux figures 4 et 5) dont les motifs recouvrent les tranchées 5. Le masque M0 de photolithographie peut être une résine photosensible qui est ensuite ôtée de l'empilement par une technique de retrait (« *stripping* » en langue anglaise), comme illustré à la figure 6.

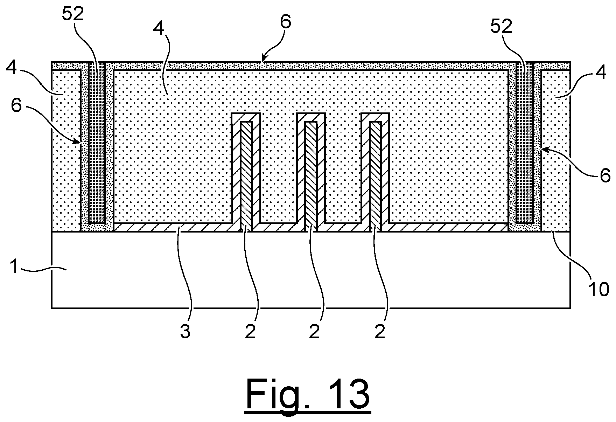

Comme illustré à la figure 13, l'étape b) est avantageusement précédée d'une étape b₀₃) de remplissage de la tranchée 5 d'un matériau 52 de type tungstène W à l'issue de l'étape b₀₂). L'étape b₀₃) est avantageusement suivie d'une étape de polissage mécano-chimique de sorte que le matériau 52 de type tungstène W affleure l'empilement.

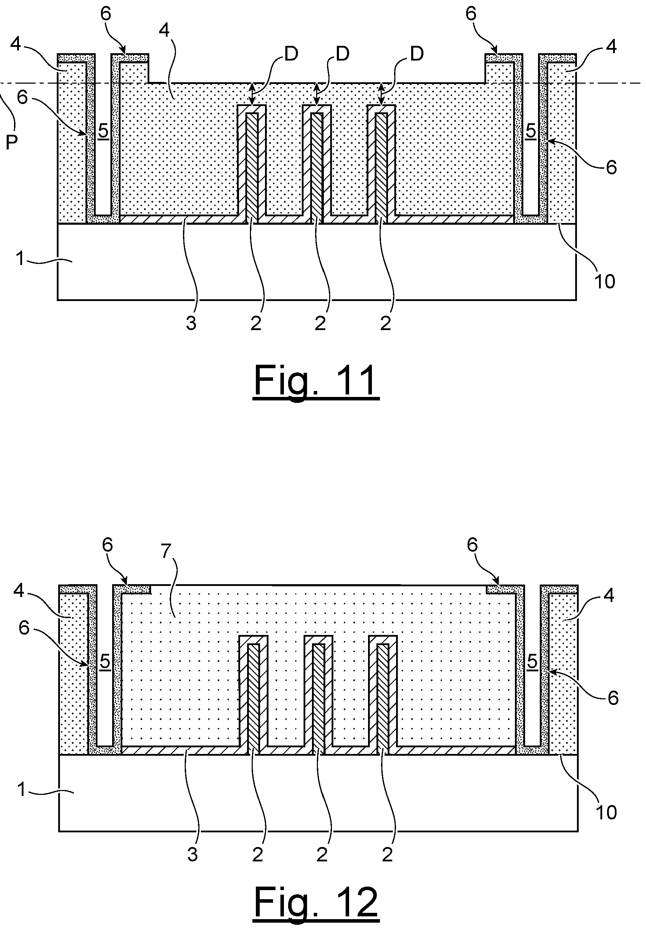

L'étape b) est avantageusement précédée d'une gravure directionnelle initiale, suivant la normale à la surface 10 du substrat 1, d'une partie superficielle de la couche diélectrique 4 de manière à atteindre une position P de l'empilement située au-dessus des pixels 2 des matrices de pixels 2, à distance D de la couche d'encapsulation 3. Comme illustré à la figure 11, la position P atteinte à la fin de la gravure directionnelle initiale (e.g. gravure sèche par plasma) doit être à une distance D suffisamment importante de la couche d'encapsulation 3 afin de ne pas détériorer la partie supérieure des pixels 2 par le fort bombardement de gaz ionisé. A titre d'exemple non limitatif, la distance D peut être de l'ordre d'une centaine de nanomètres. Plus précisément, il est possible de considérer une distance D supérieure ou égale à 100 nm avec une uniformité à la gravure de l'ordre de 3%.

### Étape c)

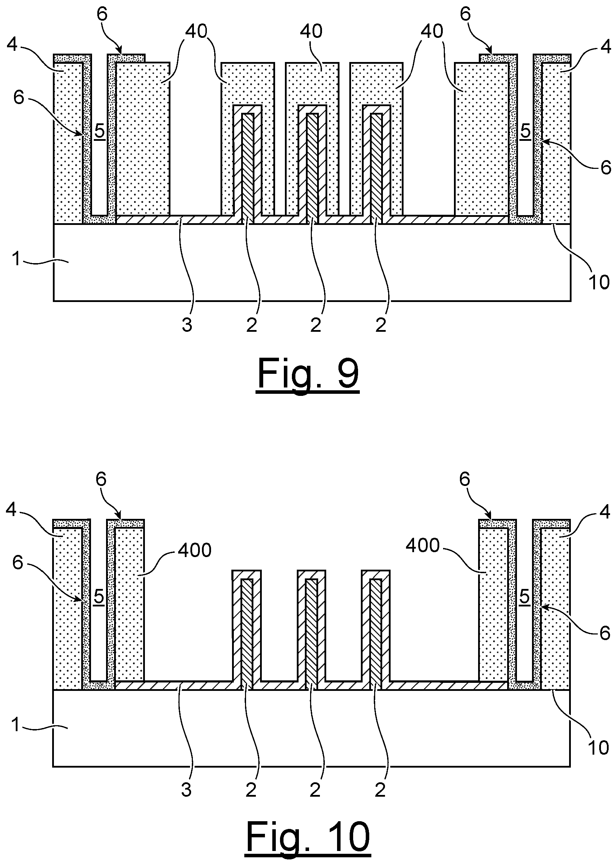

La gravure chimique sélective effectuée lors de l'étape c) est une gravure chimique sélective de la partie restante 40 de la couche diélectrique 4. Comme illustré à la figure 10, la gravure chimique sélective effectuée lors de l'étape c) est une gravure isotrope, mais peut ne pas être totale au sens où certaines portions 400 de la partie restante 40 de la couche diélectrique 4 (en particulier aux extrémités des matrices de pixels 2) peuvent demeurer à l'issue de l'étape c). Toutefois, en pratique, la gravure chimique sélective effectuée lors de l'étape c) peut être totale ou quasi-totale au sens où la totalité ou la quasi-totalité de la partie restante 40 de la couche diélectrique 4 est supprimée à l'issue de l'étape c).

L'étape c) est exécutée avec un agent de gravure chimique autorisant une gravure sélective de la partie restante 40 de la couche diélectrique 4 par rapport à la couche d'encapsulation 3. L'agent de gravure chimique avec lequel est exécutée l'étape c) est avantageusement l'acide fluorhydrique HF en phase vapeur.

Comme illustré à la figure 9, l'étape c) est avantageusement précédée d'une étape c₀) de retrait du masque M1 de photolithographie avec lequel peut être exécutée l'étape b). Le masque M1 de photolithographie peut être une résine photosensible qui est ôtée de l'empilement lors de l'étape c₀) par une technique de retrait (« *stripping* » en langue anglaise).

### Étape d)

Comme illustré à la figure 12, le procédé comporte avantageusement une étape d) de formation d'au moins une résine colorée 7 sur la couche d'encapsulation 3 à l'issue de l'étape c). Ladite au moins une résine colorée 7 est adaptée pour filtrer un spectre d'émission d'un pixel 2 sous-jacent.

Ladite au moins une résine colorée 7 peut être une résine du type matrice de polymères avec boîte quantique (« *quantum dot* » en langue anglaise). Ladite au moins une résine colorée 7 peut être une résine avec des pigments pouvant jouer le rôle de filtre coloré.

L'invention ne se limite pas aux modes de réalisation exposés. L'homme du métier est mis à même de considérer leurs combinaisons techniquement opérantes, et d'y apporter des modifications entrant dans le champ de la présente invention tel que défini par les revendications qui suivent.

## Revendications

1. Procédé de fabrication d'un dispositif électroluminescent, comportant les étapes :
a) utiliser un empilement comprenant successivement :
- un substrat (1), possédant une surface (10) ;
- des matrices de pixels (2), formées à la surface (10) du substrat (1), les pixels (2) présentant une forme colonnaire s'étendant suivant la normale à la surface (10) du substrat (1) ;
- une couche d'encapsulation (3), agencée pour recouvrir les matrices de pixels (2) ;
- une couche diélectrique (4), formée sur la couche d'encapsulation (3) ;
b) effectuer une gravure directionnelle, suivant la normale à la surface (10) du substrat (1), d'une partie de la couche diélectrique (4) s'étendant entre les pixels (2) des matrices de pixels (2) ; la couche diélectrique (4) présentant une partie restante (40) à l'issue de l'étape b) ;
c) effectuer une gravure chimique sélective de la partie restante (40) de la couche diélectrique (4) ; l'étape c) étant exécutée avec un agent de gravure chimique autorisant une gravure sélective de la partie restante (40) de la couche diélectrique (4) par rapport à la couche d'encapsulation (3).

2. Procédé selon la revendication 1, comportant une étape d) de formation d'au moins une résine colorée (7) sur la couche d'encapsulation (3) à l'issue de l'étape c), ladite au moins une résine colorée (7) étant adaptée pour filtrer un spectre d'émission d'un pixel (2) sous-jacent.

3. Procédé selon la revendication 1 ou 2, dans lequel :
- l'étape b) est exécutée avec un masque (M1) de photolithographie possédant des motifs agencés pour faire face aux pixels (2) des matrices de pixels (2) ;
- l'étape c) est précédée d'une étape c₀) de retrait du masque (M1) de photolithographie.

4. Procédé selon l'une des revendications 1 à 3, dans lequel l'étape b) est précédée des étapes :
b₀₁) former une tranchée (5) entre les matrices de pixels (2) adjacentes, possédant une paroi de fond (50) et des parois latérales (51) ;
b₀₂) déposer une couche barrière (6) sur la paroi de fond (50) et sur les parois latérales (51), la couche barrière (6) étant réalisée dans un matériau choisi en fonction de l'agent de gravure chimique avec lequel est exécutée l'étape c), de manière à obtenir une couche d'arrêt de gravure lors de l'exécution de l'étape c).

5. Procédé selon l'une des revendications 1 à 4, dans lequel l'agent de gravure chimique avec lequel est exécutée l'étape c) est l'acide fluorhydrique HF en phase vapeur.

6. Procédé selon la revendication 5 en combinaison avec la revendication 4, dans lequel la couche barrière (6) déposée lors de l'étape b₀₂) est réalisée dans au moins un matériau choisi parmi l'aluminium Al, l'alumine Al₂O₃, le nitrure d'aluminium AlN.

7. Procédé selon la revendication 5 en combinaison avec la revendication 4, ou selon la revendication 6, dans lequel l'étape b) est précédée d'une étape b₀₃) de remplissage de la tranchée (5) de tungstène W à l'issue de l'étape b₀₂).

8. Procédé selon l'une des revendications 1 à 7, dans lequel l'étape b) est précédée d'une gravure directionnelle initiale, suivant la normale à la surface (10) du substrat (1), d'une partie superficielle de la couche diélectrique (4) de manière à atteindre une position (P) de l'empilement située au-dessus des pixels (2) des matrices de pixels (2), à distance (D) de la couche d'encapsulation (3).

9. Procédé selon l'une des revendications 1 à 8, dans lequel la couche d'encapsulation (3) de l'empilement utilisé lors de l'étape a) est réalisée dans au moins un matériau choisi parmi l'aluminium Al, l'alumine Al₂O₃, le nitrure d'aluminium AlN.

10. Procédé selon l'une des revendications 1 à 9, dans lequel la couche diélectrique (4) de l'empilement utilisé lors de l'étape a) est réalisée en dioxyde de silicium SiO₂.

## Patentansprüche

1. Verfahren zur Herstellung einer Elektrolumineszenzvorrichtung, umfassend die Schritte:
a) Verwenden eines Stapels, umfassend nacheinander:
- ein Substrat (1), das eine Oberfläche (10) besitzt;
- Matrizen aus Pixeln (2), die an der Oberfläche (10) des Substrats (1) gebildet sind, wobei die Pixel (2) eine säulenartige Form aufweisen, die sich entlang der Normalen zur Oberfläche (10) des Substrats (1) erstreckt;
- eine Kapselungsschicht (3), die dazu ausgebildet ist, die Matrizen aus Pixeln (2) zu bedecken;
- eine dielektrische Schicht (4), die auf der Kapselungsschicht (3) gebildet ist;
b) Durchführen eines gerichteten Ätzens entlang der Normalen zur Oberfläche (10) des Substrats (1), wobei sich ein Teil der dielektrischen Schicht (4) zwischen den Pixeln (2) der Matrizen aus Pixeln (2) erstreckt; wobei die dielektrische Schicht (4) nach dem Schritt b) einen verbleibenden Teil (40) aufweist;
c) Durchführen eines selektiven chemischen Ätzens des verbleibenden Teils (40) der dielektrischen Schicht (4); wobei der Schritt c) mit einem chemischen Ätzmittel durchgeführt wird, das ein selektives Ätzen des verbleibenden Teils (40) der dielektrischen Schicht (4) in Bezug auf die Kapselungsschicht (3) zulässt.

2. Verfahren nach Anspruch 1, umfassend einen Schritt d) des Bildens mindestens eines farbigen Harzes (7) auf der Kapselungsschicht (3) nach dem Schritt c), wobei das mindestens eine farbige Harz (7) dazu angepasst ist, ein Emissionsspektrum eines darunter liegenden Pixels (2) zu filtern.

3. Verfahren nach Anspruch 1 oder 2, wobei:
- der Schritt b) mit einer Photolitographiemaske (M1) durchgeführt wird, die Muster besitzt, die dazu ausgebildet sind, den Pixeln (2) der Matrizen aus Pixeln (2) gegenüber zu liegen;
- dem Schritt c) ein Schritt c₀) des Entfernens der Photolitographiemaske (M1) vorausgeht.

4. Verfahren nach einem der Ansprüche 1 bis 3, wobei dem Schritt b) die folgenden Schritte vorausgehen:
b₀₁) Bilden eines Grabens (5) zwischen den benachbarten Matrizen aus Pixeln (2), der eine Bodenwand (50) und Seitenwände (51) besitzt;
b₀₂) Aufbringen einer Barriereschicht (6) auf die Bodenwand (50) und auf die Seitenwände (51), wobei die Barriereschicht (6) aus einem Material ausgeführt ist, das in Abhängigkeit von dem chemischen Ätzmittel gewählt ist, mit dem der Schritt c) durchgeführt wird, so dass eine Ätzstoppschicht bei der Durchführung des Schritts c) erhalten wird.

5. Verfahren nach einem der Ansprüche 1 bis 4, wobei das chemische Ätzmittel, mit dem der Schritt c) durchgeführt wird, Flusssäure HF in Dampfphase ist.

6. Verfahren nach Anspruch 5 in Verbindung mit Anspruch 4, wobei die bei dem Schritt b₀₂) aufgebrachte Barriereschicht (6) aus mindestens einem Material ausgeführt ist, das aus Aluminium Al, Aluminiumoxid Al₂O₃, Aluminiumnitrid AIN gewählt ist.

7. Verfahren nach Anspruch 5 in Verbindung mit Anspruch 4 oder nach Anspruch 6, wobei dem Schritt b) ein Schritt b₀₃) des Füllens des Grabens (5) mit Wolfram W nach dem Schritt b₀₂) vorausgeht.

8. Verfahren nach einem der Ansprüche 1 bis 7, wobei dem Schritt b) ein anfängliches gerichtetes Ätzen, entlang der Normalen zu der Oberfläche (10) des Substrats (1), eines oberflächlichen Teils der dielektrischen Schicht (4) vorausgeht, so dass eine Position (P) des Stapels erreicht wird, die oberhalb der Pixel (2) der Matrizen aus Pixeln (2), im Abstand (D) von der Kapselungsschicht (3), gelegen ist.

9. Verfahren nach einem der Ansprüche 1 bis 8, wobei die Kapselungsschicht (3) des bei dem Schritt a) verwendeten Stapels aus mindestens einem Material ausgeführt ist, das aus Aluminium Al, Aluminiumoxid Al₂O₃, Aluminiumnitrid AIN gewählt ist.

10. Verfahren nach einem der Ansprüche 1 bis 9, wobei die dielektrische Schicht (4) des bei dem Schritt a) verwendeten Stapels aus Siliciumdioxid SiO₂ ausgeführt ist.

## Claims

1. Process for manufacturing an electroluminescent device, comprising the following steps:
a) using a stack comprising, successively:
- a substrate (1), having a surface (10);
- matrix arrays of pixels (2) formed on the surface (10) of the substrate (1), the pixels (2) having a columnar shape and extending along the normal to the surface (10) of the substrate (1);
- an encapsulating layer (3) arranged to cover the matrix arrays of pixels (2);
- a dielectric layer (4) formed on the encapsulating layer (3);
b) performing a directional etch along the normal to the surface (10) of the substrate (1), of a portion of the dielectric layer (4) extending between the pixels (2) of the matrix arrays of pixels (2); the dielectric layer (4) having a portion (40) remaining at the end of step b);
c) performing a selective chemical etch of the remaining portion (40) of the dielectric layer (4), step c) being carried out with a chemical etchant that permits selective etching of the remaining portion (40) of the dielectric layer (4) with respect to the encapsulating layer (3).

2. Process according to Claim 1, including a step d) of forming at least one coloured resin (7) on the encapsulating layer (3) at the end of step c), said at least one coloured resin (7) being customized for filtration of an emission spectrum of an underlying pixel (2).

3. Process according to Claim 1 or 2, wherein:
- step b) is carried out with a photolithography mask (M1) having patterns arranged to face the pixels (2) of the matrix arrays of pixels (2);
- step c) is preceded by a step c₀) of removing the photolithography mask (M1).

4. Process according to one of Claims 1 to 3, wherein step b) is preceded by the following steps:
b₀₁) forming a trench (5) between adjacent matrix arrays of pixels (2) that has a bottom wall (50) and side walls (51);
b₀₂) depositing a barrier layer (6) on the bottom wall (50) and on the side walls (51), the barrier layer (6) being made of a material selected according to the chemical etchant with which step c) is carried out, so as to obtain an etch stop layer during performance of step c).

5. Process according to one of Claims 1 to 4, wherein the chemical etchant with which step c) is carried out is vapour-phase hydrofluoric acid (HF).

6. Process according to Claim 5 in combination with Claim 4, wherein the barrier layer (6) deposited during step b₀₂) is made of at least one material selected from aluminium (Al), alumina (Al₂O₃) and aluminium nitride (AIN).

7. Process according to Claim 5 in combination with Claim 4 or according to Claim 6, wherein step b) is preceded by a step b₀₃) of filling the trench (5) with tungsten (W) at the end of step b₀₂).

8. Process according to one of Claims 1 to 7, wherein step b) is preceded by an initial directional etch along the normal to the surface (10) of the substrate (1), of a surface portion of the dielectric layer (4) so as to reach a position (P) in the stack situated above the pixels (2) of the matrix arrays of pixels (2), at a distance (D) from the encapsulating layer (3).

9. Process according to one of Claims 1 to 8, wherein the encapsulating layer (3) of the stack used in step a) is made of at least one material selected from aluminium (Al), alumina (Al₂O₃) and aluminium nitride (AIN).

10. Process according to one of Claims 1 to 9, wherein the dielectric layer (4) of the stack used in step a) is made of silicon dioxide (SiO₂).
